# EUROPEAN PATENT APPLICATION

(11) **EP 2 219 420 A1**
(43) Date of publication of application: **18.08.2010**
(21) Application number: 08853957.2
(22) Date of filing: 13.11.2008
(51) Int. Cl.: H05B 33/22, H01L 51/50, H05B 33/10, H05B 33/12

(54) **ELECTRONIC DEVICE, DISPLAY APPARATUS AND METHOD FOR MANUFACTURING ELECTRONIC DEVICE**

(30) Priority: 30.11.2007 JP 2007311641
(71) Applicant: Sumitomo Chemical Company, Limited, Tokyo 104-8260 (JP)
(72) Inventor: KASAHARA, Kenji, Tsukuba-shi Ibaraki 300-3261 (JP); NISHIOKA, Yukiya, Nara-shi Nara 631-0034 (JP); MATSUMURO, Tomonori, Tsukuba-shi Ibaraki 305-0051 (JP)
(74) Representative: Jackson, Martin Peter
(86) International application number: PCT/JP2008/070716
(87) International publication number: WO 2009/069476

(57) **Abstract**

Provided is a solution for narrowing of a light emitting region, increasing of leak current at an edge of a functional layer, peeling of the functional layer, or the like caused by non-uniform thickness of the functional layer at the edges thereof. Provided is an electronic device comprising a substrate; a conductive functional layer formed on the substrate; and an edge covering layer that covers edges of the functional layer, wherein the functional layer includes a functional region that is not covered by the edge covering layer. This functional layer may include a non-functional region that is made non-functional by covering the functional layer with the edge covering layer. The edge covering layer may be adhered to the substrate by an adhesion force that is greater than an adhesion force between the substrate and the functional layer.

## Description

### TECHNICAL FIELD

The present invention relates to an electronic device, a display apparatus, and an electronic device manufacturing method. In particular, the present invention relates to an electronic device, a display apparatus, and an electronic device manufacturing method for preventing problems caused by non-uniformity in thickness of a functional layer provided on an electronic device.

### BACKGROUND ART

An electronic device having a functional layer can be used in a display apparatus. A known electronic device having functional layers formed at prescribed locations on a substrate is disclosed in Patent Document 1, and this electronic device is formed by forming a bank layer to prevent spilling of the ejected liquid in advance on a substrate, using an ink jet technique to eject a solution for forming a functional layer into the regions surrounded by the bank layer, and using the functional layers obtained by letting the solution dry. When forming this electronic device, no special processes are applied to the edges of the functional layers.

Patent Document 2 discloses an electronic device that has functional layers formed at prescribed locations on a substrate without forming a bank layer on the substrate. In this electronic device, a film made of functional layer material formed uniformly on the substrate undergoes patterning using photolithography to form functional layers. In this electronic device as well, no special processes are applied to the edges of the functional layers.

Patent Document 1: Domestic re-publication of PCT international application No. 99/010862
Patent Document 2: Japanese Patent Application Publication No. 2005-32735

### DISCLOSURE OF THE INVENTION

### PROBLEMS TO BE SOLVED BY THE INVENTION

However, with conventional techniques, there is a problem with the uniformity of the functional layers in the electronic device. For example, when the functional layers are light emitting layers in organic EL elements, there are problems such as a drop in brightness at the edges of the light emitting layers, narrower light emitting regions, and increase in leak current at the edges. Therefore, electronic devices with highly uniform functional layers are desired. The objective of the present invention is to provide an electronic device with highly uniform functional layers.

Therefore, it is an object of an aspect of the innovations herein to provide an electronic device, a display apparatus, and an electronic device manufacturing method, which are capable of overcoming the above drawbacks accompanying the related art. The above and other objects can be achieved by combinations described in the independent claims. The dependent claims define further advantageous and exemplary combinations of the innovations herein.

Therefore, in order to solve the above problems, the inventors investigated a configuration for an electronic device having highly uniform functional layers. As a result, the inventors discovered that an electronic device having highly uniform functional layers could be obtained by covering the edges of the functional layers with edge covering layers, thereby arriving at the present invention. Furthermore, by patterning a uniformly formed film on the substrate without forming a barrier portion on the substrate, or by forming a film in a region that is part of the substrate without forming the barrier portion on the substrate, the functional layers can be formed on the element formation regions of the substrate. By applying a further prescribed layer to an electronic device having functional layers formed in this way, an electronic device having highly uniform functional layers can be obtained, which leads to the completion of the present invention.

According to a first aspect of the present invention, provided is an electronic device comprising a substrate; a conductive functional layer formed on the substrate; and an edge covering layer that covers edges of the functional layer, wherein the functional layer includes a functional region that is not covered by the edge covering layer. According to a second aspect of the present invention, provided is an electronic device comprising a substrate; a functional layer formed on an element formation region of the substrate by patterning a uniformly formed film on the substrate without forming a barrier portion on the substrate, or by forming a film in a region that is part of the substrate without forming the barrier portion on the substrate; and an edge covering layer that covers edges of the functional layer, wherein the functional layer includes a functional region that is not covered by the edge covering layer. According to a third aspect of the present invention, provided is an electronic device comprising a substrate; a barrier portion that is formed on the substrate; a functional layer that is formed on an element formation region defined by the barrier portion and that has a uniform thickness in a central region of the element formation region; and an edge covering layer that covers edges of the functional layer, wherein the functional layer includes a functional region that is not covered by the edge covering layer. According to a fourth aspect of the present invention, provided is an electronic device comprising a substrate; a barrier portion that is formed on the substrate; a functional layer formed on an element formation region defined by the barrier portion; and an edge covering layer that covers edges of the functional layer, wherein the functional layer includes a region that is not covered by the edge covering layer and after applying a solution that includes a photosensitive resin to cover the functional layer, the edge covering layer is formed by removing the photosensitive resin covering a functional region that is not covered by the edge covering layer.

### Effect of the Invention

The present invention can provide an electronic device with highly uniform functional layers.

### BRIEF DESCRIPTION OF THE DRAWINGS

Fig. 1 shows a display apparatus 101 according to an embodiment of the present invention.
Fig. 2 is a cross-sectional view of organic EL elements 201.
Fig. 3 is a cross-sectional view showing a method for manufacturing organic EL elements 201.
Fig. 4 is a cross-sectional view showing a method for manufacturing organic EL elements 201.
Fig. 5 is a cross-sectional view showing a method for manufacturing organic EL elements 201.
Fig. 6 is a cross-sectional view showing a method for manufacturing organic EL elements 201.
Fig. 7 is a cross-sectional view showing a method for manufacturing organic EL elements 201.
Fig. 8 is a cross-sectional view showing a method for manufacturing organic EL elements 201.
Fig. 9 is a cross-sectional view showing a method for manufacturing organic EL elements 201.
Fig. 10 is a magnified view of the 240 portion of Fig. 9.
Fig. 11 is a cross-sectional view of organic EL elements 401, which are examples of other organic EL elements.
Fig. 12 is a cross-sectional view showing a method for manufacturing organic EL elements 401.
Fig. 13 is a cross-sectional view showing a method for manufacturing organic EL elements 401.
Fig. 14 is a cross-sectional view showing a method for manufacturing organic EL elements 401.
Fig. 15 is a cross-sectional view showing a method for manufacturing organic EL elements 401.
Fig. 16 is a cross-sectional view showing a method for manufacturing organic EL elements 401.
Fig. 17 is a cross-sectional view showing a method for manufacturing organic EL elements 401.
Fig. 18 is a magnified view of the 440 portion of Fig. 17.

### List of Reference Numerals

- 101: Display apparatus
- 201: Organic EL element
- 202: Substrate
- 204: Anode
- 206: Hole injection layer
- 208: Blue light emitting layer
- 210: Red light emitting layer
- 212: Edge covering layer
- 214: Cathode
- 230: Negative resist
- 232: Photomask
- 300: Bank
- 401: Organic EL element
- 402: Substrate
- 404: Anode
- 406: Hole injection Layer
- 408: Blue light emitting layer
- 410: Red light emitting layer
- 412: Edge covering layer
- 414: Cathode
- 430: Negative resist
- 432: Photomask
- Ro: Lifted region
- Rs: Thin film region
- Rt: Thin film region

### BEST MODE FOR CARRYING OUT THE INVENTION

Hereinafter, some embodiments of the present invention will be described. The embodiments do not limit the invention according to the claims, and all the combinations of the features described in the embodiments are not necessarily essential to means provided by aspects of the invention.

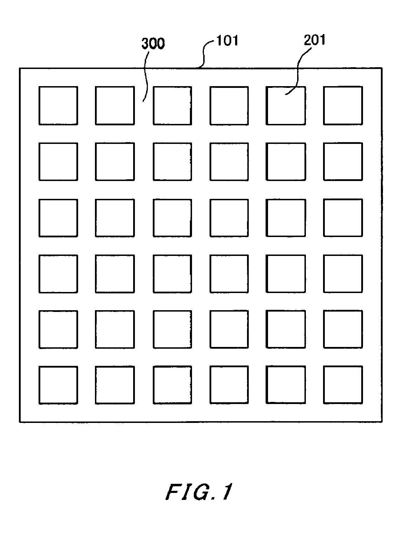

Fig. 1 shows a display apparatus 101 according to an embodiment of the present invention. The display apparatus 101 includes organic EL elements 201 arranged in a matrix. The organic EL elements 201 are separated from each other by banks 300. The organic EL elements 201 are examples of electronic devices, and the banks 300 are examples of a barrier portion.

In the display apparatus 101 of the present embodiment, organic EL elements 201 that are light emitting elements are used as examples of display elements. However, the display elements are not limited to light emitting elements such as the organic EL elements, and may instead be liquid crystal display elements including electrodes or the like generating a magnetic field as a functional layer.

In the display apparatus 101, banks 300 are oriented in rows and columns, such that the element formation regions of the organic EL elements 201 are arranged in a matrix. Specifically, the banks 300 are oriented in rows and columns on the substrate, such that the element formation regions are arranged in a matrix on the substrate. The element formation regions of the organic EL elements 201 are separated from each other by the banks 300, and a functional layer that realizes the function of the organic EL element 201 is formed on each element formation region. The functional layer is conductive. The edges of each functional layer are covered by an edge covering layer. The functional layer includes a non-functional region that is covered by the edge covering layer and a functional region that is not covered by the edge covering layer.

Here, the banks 300 are used as an example of a component for separating the element formation regions of the organic EL elements 201, but the element formation regions may be formed using a different technique. For example, the element formation regions can be arranged in a matrix on the substrate by patterning a uniform film on the substrate or by selectively coating a film on the substrate to form the functional layer, without forming the banks 300 on the substrate. Specifically, after forming a uniform film on the substrate to serve as the functional layer, the element formation regions may be formed using a patterning technique such as etching. As another example, the element formation regions can be formed by selectively coating a region of the substrate with a material serving as the functional layer.

By partitioning the element formation regions in this way, the element formation regions can be arranged in a matrix on the substrate. Even when the method used to partition the element formation regions of the organic EL elements 201 does not involve the banks 300, the edges of the functional layers of the element formation regions are covered by the edge covering layers. Accordingly, in this case as well, the functional layers each include a non-functional region that is covered by the edge covering layer and a functional region that is not covered by the edge covering layer.

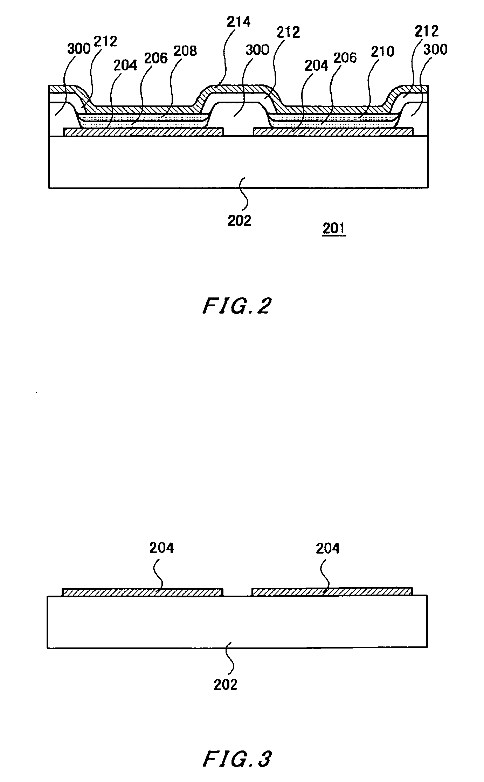

Fig. 2 is a cross-sectional view of organic EL elements 201. Fig. 2 shows two organic EL elements 201. Each organic EL element 201 includes a substrate 202, an anode 204, a hole injection layer 206, a blue light emitting layer 208 or a red light emitting layer 210, an edge covering layer 212, a cathode 214, and banks 300.

Fig. 2 shows a blue light emitting layer 208 and a red light emitting layer 210, and in this case, an organic EL element 201 provided with the blue light emitting layer 208 corresponds to a blue pixel and an organic EL element 201 provided with the red light emitting layer 210 corresponds to a red pixel. It is also obvious that an organic EL element 201 corresponding to a green pixel may be provided. Organic EL elements 201 can be formed to display three or more colors. The emitted light may be the three primary colors of cyan, magenta, and yellow.

The substrate 202 includes anodes 204 and banks 300 on the surface thereof. The anodes 204 are examples of bottom electrodes, and the banks 300 are examples of a barrier portion. The banks 300 act as barriers for partitioning the element formation regions of the organic EL elements 201 as described above, and therefore serve as barriers of the functional layers of the organic EL elements 201. The banks 300 may be insulators, and may be formed of a photosensitive resin. If the banks 300 are a photosensitive resin, the banks can be easily formed using photolithography.

The anodes 204 are formed on the surface of the substrate 202. Hole injection layers 206 are formed on the anodes 204. It should be noted that the region around the anodes 204 is covered by the banks 300, and so the hole injection layers 206 are formed on portions of the anodes 204. The anodes 204 are examples of bottom electrodes.

The hole injection layers 206 are formed on portions of the anodes 204. Since the anodes 204 are formed on the substrate 202, the hole injection layers 206 are also formed on the substrate 202. The hole injection layers 206 are examples of functional layers.

The blue light emitting layer 208 and the red light emitting layer 210 are formed on the hole injection layers 206. Since the hole injection layers 206 and the anodes 204 are formed on the substrate 202, the blue light emitting layer 208 and the red light emitting layer 210 are also formed on the substrate 202. The blue light emitting layer 208 and the red light emitting layer 210 are examples of functional layers. If the blue light emitting layer 208 and the red light emitting layer 210 are not separated, this configuration is simply referred to as a light emitting layer. The blue light emitting layer 208 and the red light emitting layer 210 are desirably organic light emitting layers.

The hole injection layers 206, the blue light emitting layer 208, and the red light emitting layer 210 are examples of functional layers. In the following description, the term "functional layer" can refer to any one of the hole injection layers 206, the blue light emitting layer 208, and the red light emitting layer 210. Furthermore, a hole injection layer 206 and the blue light emitting layer 208 can be referred to collectively as a "functional layer," as can a hole injection layer 206 and the red light emitting layer 210. The hole injection layers 206 are desirably organic. The hole injection layers 206 are examples of organic carrier injection layers.

The edge covering layers 212 cover the banks 300 and the edges of a hole injection layer 206 and the blue light emitting layer 208 and of a hole injection layer 206 and the red light emitting layer 210. The edge covering layers 212 are adhered to the substrate 202 via the banks 300 with an adhesive force greater than the adhesive force between the substrate 202 and the functional layers. As a result, the edges of the functional layers are prevented from peeling off. The edge covering layers 212 may be insulators.

The functional layers are formed such that the edges thereof are between the edge covering layers 212 and the substrate 202 or the banks 300. Accordingly, a short circuit between the edges thereof and top electrodes is prevented by forming the edge covering layers 212 as insulators.

The functional layers are formed on the element formation regions defined by the banks 300. Each functional layer is formed to have a uniform thickness in a central region of the element formation region. Here, the element formation regions that are not covered by the edge covering layers can define the central regions of the element formation regions. Since each functional layer has a uniform thickness in the central region of the element formation region, uneven light emission is prevented. Here, having a "uniform thickness" means that the deviation from the average thickness or the minimum thickness and maximum thickness are within a range that does not cause functional problems for the functional layer. For example, the minimum and maximum thicknesses should be within 10% of the average thickness.

The edge covering layers 212 can be formed on the functional layers using a coating or painting technique. This coating technique may be spin coating, casting, microgravure coating, gravure coating, bar coating, roll coating, wire bar coating, deep coating, slit coating, capillary coating, spray coating, or nozzle coating. Possible painting techniques include gravure printing, screen printing, flexographic printing, offset printing, inverse printing, and ink jet printing.

The edge covering layers 212 may be made of photosensitive resin. If the edge covering layers 212 are a photosensitive resin, regions of the functional layers that are not covered, i.e. functional regions of the functional layers, can be easily formed using photolithography. Specifically, the edge covering layers 212 may be formed by coating with a photosensitive resin covering the functional layers and then removing the photosensitive resin from the functional regions.

The thickness of each edge covering layer 212 is between 10 nm and 10 µm, for example. This thickness is preferably between 100 nm and 5 µm, and more preferably between 1000 nm and 3 µm, for example. The edge covering layers 212 cover each set of a hole injection layer 206 and a blue light emitting layer 208 or a hole injection layer 206 and a red light emitting layer 210 from the edge of the element formation region to a location that is between 2 µm and 20 µm, preferably between 5 µm and 15 µm, inward.

The cathodes 214 cover the blue light emitting layer 208, the red light emitting layer 210, and the edge covering layers 212. The cathodes 214 are examples of top electrodes. As described above, the edges of the functional layers are covered by the edge covering layers 212, thereby preventing a leak at the edges of the functional layers 212. In particular, leaks are prevented between the cathodes 214 and the hole injection layers 206.

The cathodes 214 and the anodes 204 are arranged to face each other. In this way, electrode pairs are formed. The cathodes 214 and the anodes 204 sandwich the functional layers such as the hole injection layers 206, the blue light emitting layer 208, and the red light emitting layer 210, and may supply current to these functional layers. The edges of the functional layers are covered by the edge covering layers 212, thereby preventing a current leak between the cathodes 214 and the anodes 204. Specifically, the edge covering layers 212 insulate the leak current between the cathodes 214 and the anodes 204 at the edges of the functional layers.

The blue light emitting layer 208 and the red light emitting layer 210 have their edges covered by the edge covering layers 212, and so the blue light emitting layer 208 and the red light emitting layer 210 each include functional regions that are not covered by the edge covering layers 212. The functional regions are regions that realize the functions of the blue light emitting layer 208 and the red light emitting layer 210, and in this specific case, are light emitting regions. On the other hand, by covering the blue light emitting layer 208 or the red light emitting layer 210 with the edge covering layers 212, non-functional regions can be formed in which the blue light emitting layer 208 and the red light emitting layer 210 are non-functional. As a specific example, regions that do not emit light can be formed.

The set of a hole injection layer 206 and the blue light emitting layer 208 and the set of a hole injection layer 206 and the red light emitting layer 210 each have a lifted region at the edges thereof formed by being lifted on a portion of a bank 300. The edge covering layers 212 cover the lifted regions of the functional layers. The set of a hole injection layer 206 and the blue light emitting layer 208 and the set of a hole injection layer 206 and the red light emitting layer 210 each have a thin film region formed at the edges thereof, and this thin film region has a thickness that is less than the average thickness of the functional region. The edge covering layers 212 also cover the thin film regions of the functional layers.

Figs. 3 to 9 are cross-sectional views showing a method for manufacturing organic EL elements 201. As shown in Fig. 3, the substrate 202 is prepared and a transparent conductive film, such as ITO (indium tin oxide) is deposited on the substrate 202. Next, the deposited conductive film is patterned using photolithography and etching to form the anodes 204.

A thin film transistor with a carrier layer formed of silicon or the like may be formed on the substrate 202. Instead, the substrate 202 of the present embodiment may be a substrate 202 on which a thin film transistor or the like is already formed.

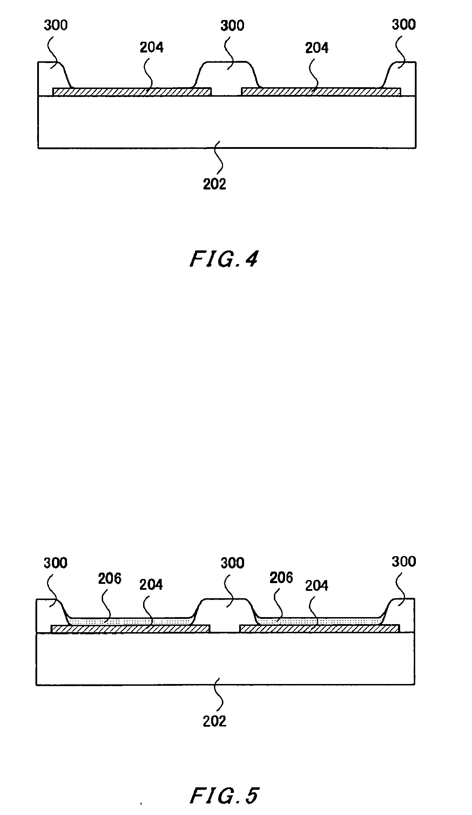

As shown in Fig. 4, after a photosensitive resin or the like is applied to the entire surface of the substrate 202 on which the anodes 204 are formed and pre-baking is performed, an appropriate mask is arranged and an exposure process is performed. After this, development and post-baking are performed to form the banks 300.

As shown in Fig. 5, a coating process or the like may be used to form the hole injection layers 206. After an organic solvent containing a hole injection material is dripped for coating, the hole injection layers 206 can be formed by baking at 200 °C for 30 minutes in a nitrogen atmosphere.

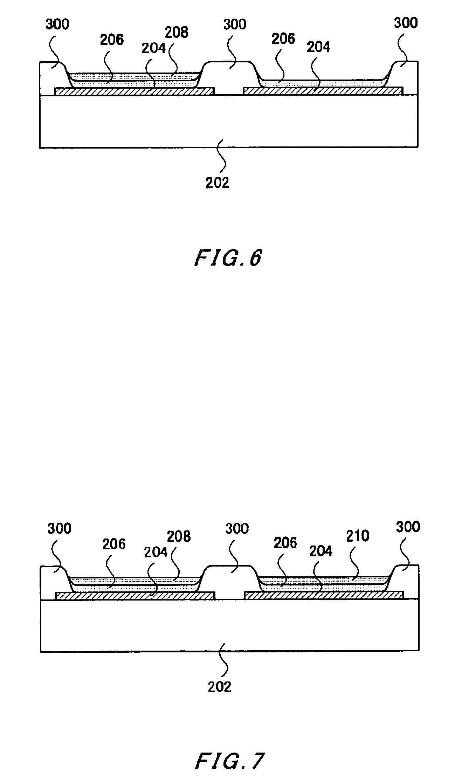

As shown in Fig. 6, the blue light emitting layer 208 is formed on the substrate 202 on which the hole injection layers 206 are formed. The blue light emitting layer 208 may be formed using the method described below. After an organic solvent containing a light emitting material is dripped and spin coating is performed, the light emitting layer can be formed by baking at 130 °C.

A resist mask can be formed on the light emitting layer by spin coating with a positive resist, pre-baking, performing mask exposure, developing, and post-baking. After this, etching may be used to remove regions of the light emitting layer that are not covered by the resist mask. The resist is then peeled off to form the blue light emitting layer 208.

As shown in Fig. 7, the red light emitting layer 210 is formed using the same method as described in Fig. 6. In order to form light emitting layers with several colors, the same process for applying the light emitting layer and patterning should be repeated.

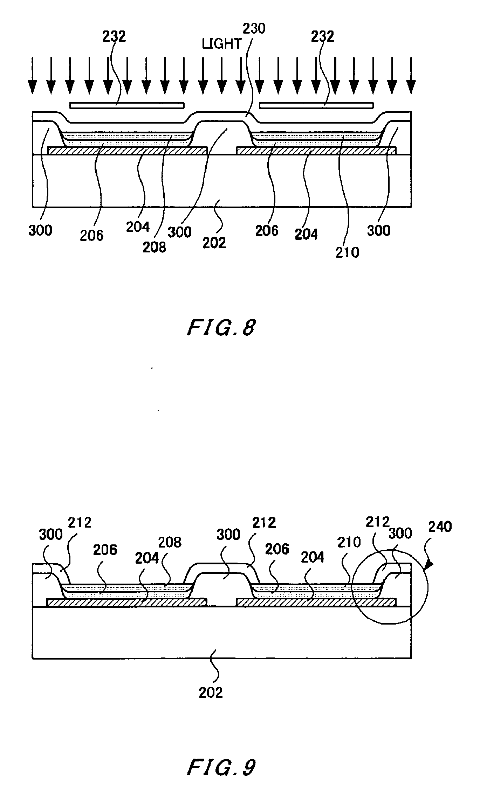

As shown in Fig. 8, a negative resist 230 with an epoxy resin base, for example, is coated on the substrate 202 on which the blue light emitting layer 208 and the red light emitting layer 210 are formed. After the pre-baking, the photomask 232 is disposed and the negative resist 230 is exposed.

As shown in Fig.9, the edge covering layers 212 are formed by developing the exposed regions of the negative resist 230. After this, if a vapor deposition technique or the like is used to deposit a metal film to form the cathodes 214, the organic EL elements 201 shown in Fig. 2 can be formed.

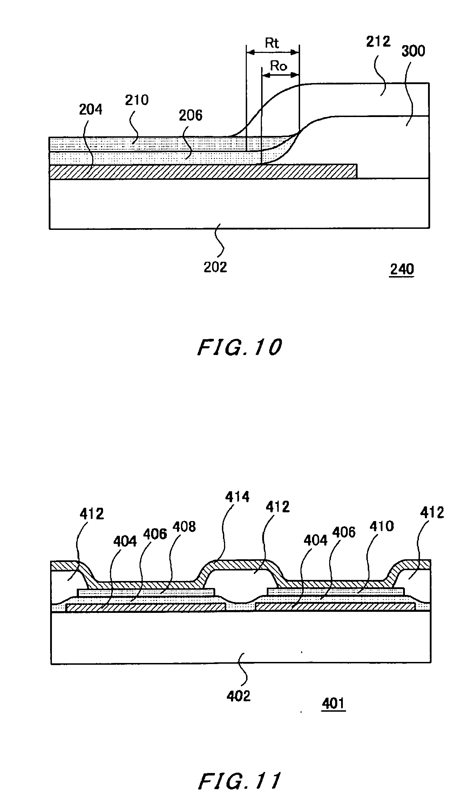

Fig. 10 is a magnified view of the 240 portion of Fig. 9. The set of a hole injection layer 206 and the red light emitting layer 210 has a lifted region Ro at the edges thereof formed by being lifted on a portion of a bank 300. The set of a hole injection layer 206 and the red light emitting layer 210 has a thin film region Rt formed at the edges thereof, and this thin film region has a thickness that is less than the average thickness of the functional region. The edge covering layers 212 cover the lifted regions Ro and the thin film regions Rt.

The following is a more detailed description of the various components described above. The substrate 202 has electrodes or elements formed thereon, and may be any material that does not change when organic layers are formed thereon, such as glass, plastic, polymer film, silicon, or a layered structure containing a plurality of these materials. The substrate 202 may be a commercially available product or may be manufactured using a known method.

Examples of plastic substrates that can be used include PEN (polyethylene naphthalate), PC (polycarbonate), TAC (triacetylcellulose), PET (polyethylene terephthalate), and PES (polyether sulphone). If the light emitting element being formed is a top-emitting type organic EL element, the substrate 202 may be opaque, such as a stainless steel substrate or a single crystal semiconductor substrate.

The anodes 204 are preferably transparent or translucent electrodes, as this allows the resulting element to emit light through the anodes 204. These transparent or translucent electrodes may be a thin film made of a metal oxide, a metal sulfide, or a metal having high electric conductivity. The anodes 204 are preferably made of a material with high transmittance and can be selected depending on the organic layer to be used.

More specifically, these electrodes may be gold, platinum, silver, copper, or a film (NESA or the like) formed using a conductive glass including indium oxide, zinc oxide, tin oxide, or a compound of these materials such as indium tin oxide (ITO) or indium zinc oxide. These electrodes are preferably made of ITO, indium zinc oxide, or tin oxide. The manufacturing method may be vacuum deposition, sputtering, ion plating, cladding, or the like. The anodes 204 may be an organic transparent conductive film such as polyaniline or a derivative thereof, polythiophene or a derivative thereof, or the like.

The anodes 204 may be a material that reflects light, and such a material is preferably a metal, metal oxide, or metal sulfide with a work function no less than 3.0 eV. The thickness of the anodes 204 can be set as desired while considering the optical transmittance and electric conductivity, and a thickness from 10 nm to 10 µm is acceptable, but the thickness is preferably from 20 nm to 1 µm and more preferably from 50 nm to 500 nm.

In order to facilitate charge injection, a layer that includes phthalocyanines, conductive polymers, carbon, or the like may be provided, or a layer with an average thickness no greater than 2 nm and including metal oxides, metal fluorides, organic insulating material, or the like may be provided on the anodes 204. If the light emitting element being formed is a top-emitting type organic EL element, the anodes 204 may be made of an opaque material or formed as layered structures containing a transparent material and an opaque material.

The hole injection layers 206 improve the efficiency of hole injection from the anodes 204. Hole transport layers may be formed between the hole injection layers 206 and the light emitting layers. The hole transport layers improve the hole injection from the anodes, the hole injection layers 206, or a hole transport layer closer to an anode 204. If the hole injection layers 206 or the hole transport layers function to dam transport of electrons, these layers may function as an electron blocking layer.

The function of damming the transport of the electrons can be confirmed by a decrease in the hole current value when elements that allow an electron current to flow but do not allow a hole current to flow are created. The material for forming the hole injection layers may be amorphous carbon, polyaniline, polythiophene derivatives, phenylamine, starburst amine, phthalocyanine, or an oxide such as vanadium oxide, molybdenum oxide, titanium oxide, or aluminum oxide.

The blue light emitting layer 208 or the red light emitting layer 210 is preferably an organic light emitting layer, and includes an organic material that emits mostly fluorescent or phosphorescent light (monomer compounds and polymer compounds). The blue light emitting layer 208 or the red light emitting layer 210 may include a dopant material. The blue light emitting layer 208 or the red light emitting layer 210 may include material that can emit light when current flows therethrough or when voltage is applied thereto. Examples of the material that can be used for such light emitting layers includes distilled biphenyl materials, dimesitylboryl materials, stilbene materials, dipyridyl dicyanobenzene materials, benzoxazol materials, distilled materials, carbazole materials, and dibenzochrysene materials. Other materials that can be used include arylamine materials, pyrene-substituted oligothiophene materials, PPV oligomer materials, carbazole materials, and polyfluorene materials.

The thicknesses of the blue light emitting layer 208 and the red light emitting layer 210 are not particularly limited, and can be changed depending on the desired design. For example, thicknesses from 10 to 200 nm are preferable. If the thickness is below this minimum value, then the electrons and the holes exhibit insufficient recombining, the brightness is insufficient, and various structural problems can occur. On the other hand, if the thickness is above this maximum value, a higher voltage must be applied.

In addition to the examples described above, the material for the blue light emitting layer 208 or the red light emitting layer 210 may be the following. Examples of colorants include a cyclopentamine derivative compound, a tetraphenyl butadiene derivative, a triphenylamine derivative, an oxadiazole derivative, a pyrazoloquinoline derivative, and a distyrylbenzene derivative. Other examples include a distyrylarylene derivative, a pyrrole derivative, a thiophene ring compound, a pyridine ring compound, a perinone derivative, a perylene derivative, an oligothiophene derivative, a trifumanylamine derivative, an oxadiazole dimer, and a pyrazoline dimer.

Examples of metal complex materials include materials in which the center metal is A1, Zn, Be or the like, or a rare earth metal such as Tb, Eu, or Dy while the ligand is oxadiazole, thiadiazole, phenylpyridine, phenylbenzoimidazole, quinoline or other structures. For example, this metal complex material may be a metal complex having light emission from a triplet excited state, such as an iridium complex or a platinum complex, or may be an alumiquinolinol complex, a benzoquinolinol beryllium complex, a benzoxazolyl zinc complex, a benzothiazole zinc complex, an azomethyl zinc complex, a porphyrin zinc complex, or a europium complex.

Examples of polymeric materials include a polyparaphenylenevinylene derivative, a polythiophene derivative, a polyparaphenylene derivative, and a polysilane derivative. Other examples include a polyacetylene derivative, a polyfluorene derivative, a polyvinylcarbazole derivative, and polymers obtained by polymerizing the colorants or metal complex materials described above.

Examples of blue light emitting materials from among the above light emitting materials include a distyrylarylene derivative, an oxadiazole derivative, and polymers thereof. Further examples include a polyvinylcarbazole derivative, a polyparaphenylene derivative, and a polyfluorene derivative. From among these materials, a polyvinylcarbazole derivative, a polyparaphenylene derivative, and a polyfluorene derivative are preferable.

Examples of green light emitting materials include a quinacridone derivative, a coumarin derivative, and polymers thereof. Further examples include a polyparaphenylenevinylene derivative and a polyfluorene derivative. From among these materials, a polyparaphenylenevinylene derivative and a polyfluorene derivative are preferable.

Examples of red light emitting materials include a coumarin derivative, a thiophene ring compound, and polymers thereof. Further examples include a polyparaphenylenevinylene derivative, a polythiophene derivative, and a polyfluorene derivative. From among these materials, a polyparaphenylenevinylene derivative, a polythiophene derivative, and a polyfluorene derivative are preferable.

A dopant may be added to the light blue light emitting layer 208 or the red light emitting layer 210 to improve the light emission efficiency or to change the light emission wavelength. Examples of possible dopants include a perylene derivative, a coumarin derivative, a rubrene derivative, a quinacridone derivative, a squalium derivative, a porphyrin derivative, a styryl dye, a tetracene derivative, a pyrazolone derivative, decacyclene, and phenoxazone. The thickness of each of the blue light emitting layer 208 and the red light emitting layer 210 can be from 2 nm to 200 nm.

The method for forming the blue light emitting layer 208 and the red light emitting layer 210 containing the organic compound may be a vacuum deposition method, a transfer method, or a coating method for applying a solution including the light emitting material to the top of the substrate. Specific examples of the solvents used when forming the film from a solution are the same as the solvents used for dissolving the hole transport material when forming the hole transport layer from a solution, as described above.

From among these materials, organic solvents that can be melted can be used for film formation with coating techniques, and are therefore preferable for use in manufacturing. When manufacturing the organic EL elements 201, effective manufacturing can be achieved by using polymer light emitting material that is an organic solvent that can be melted. Specifically, the blue light emitting layer 208 or the red light emitting layer 210 can be manufactured easily by coating with a solution obtained by melting a light emitting material, allowing the solution to dry, and then removing the solvent. The same process can be applied even when a light emitting material or an electron transport material is mixed in, thereby providing more advantages for manufacturing.

The ideal thicknesses of the blue light emitting layer 208 and the red light emitting layer 210 change depending on the material used, and should be selected to achieve the most preferable values for drive voltage and light emission efficiency. For example, the thicknesses may be between 1 nm and 1 µm, preferably between 2 nm and 500 nm. This thickness is more preferably 5 nm and 200 nm.

The method for applying the solution including the light emitting material to the top of the substrate may be a coating method. This coating method may be spin coating, casting, microgravure coating, gravure coating, bar coating, roll coating, wire bar coating, deep coating, slit coating, capillary coating, spray coating, or nozzle coating. Other possible methods include gravure printing, screen printing, flexographic printing, offset printing, inverse printing, and ink jet printing.

Preferable methods include gravure printing, screen printing, flexographic printing, offset printing, inverse printing, and ink jet printing, since pattern formation and multi-color separation are easily achieved with these methods. In the case of a sublimable monomer compound, vacuum deposition can be used. Furthermore, the light emitting layer can be formed on a prescribed region by thermal transferring or laser transferring.

When the thin film is layered using a solution, the layers contacting the solvent are preferably not dissolved by the solution. When forming the layers from a solution, the solution used to form the thin film is selected to be a type that does not dissolve the layers contacting the solution, or the layering is performed with the solution after the layers contacting the solution are protected from dissolving by photo crosslinking or thermal crosslinking.

The solution used for printing techniques, e.g. an ink compound, should include at least one type of a fluorescent polymer material, e.g. a polymer light emitting material. In addition to the fluorescent polymer material, hole transport material, electron transport material, light emitting material, a solvent, a stabilizer, or the like can be included as additives.

The viscosity of the ink compound depends on the printing technique used. In order to prevent clogging or splattering during ejection of the ink compound via an ejection apparatus, such as in ink jet printing, the viscosity of the ink compound is preferably between 1 and 20 mPa·s at 25 °C. A viscosity between 5 and 20 mPa·s is more preferable, and a viscosity between 7 and 20 mPa•s is even more preferable.

In addition to the polymer compound, the solution used for the printing, i.e. the ink compound, may include an additive for adjusting the viscosity and/or surface tension. Such an additive may be a poor solvent or a polymer compound with a high molecular weight, e.g. thickening agent, for increasing the viscosity, a compound with a low molecular weight for decreasing the viscosity, a surface tension modifier for decreasing the surface tension, or a suitable combination of these materials.

The polymer compound with a high molecular weight should not interfere with the light emission or the charge transport, and should be dissolved in the same solvent as the polymer fluorescent material. For example, this polymer compound may be polymethyl methacrylate or polystyrene with a high molecular weight, or may be a polymer fluorescent material with a high molecular weight. The weight-average molecular weight of the polystyrene is preferably greater than 500,000, and more preferably greater than 1,000,000.

A poor solvent may be used as a thickening agent. Specifically, the viscosity can be increased by adding the poor solvent in a small amount relative to the solids in the solution. When adding a poor solvent to increase viscosity, the type of the solvent and the amount of the additive can be selected such that the solids in the solution do not separate. When considering stability during storage, the amount of the poor solvent is preferably less than 50 wt% of the entire solution, and more preferably less than 30 wt%.

The solution may contain an antioxidant to improve the storage stability. The antioxidant should not interfere with the light emission or the charge transport, and should be dissolvable in the same solvent as the polymer fluorescent material. Such antioxidants include phenolic antioxidants and phosphoric antioxidants, for example.

The type of solvent used is not particularly limited, but the solvent can preferably dissolve or uniformly diffuse a material other than the solvent used for the ink compound. For example, chlorine solvents, ether solvents, aromatic hydrocarbon solvents, aliphatic hydrocarbon solvents, ketone solvents, ester solvents, polyhydrate alcohols and derivatives thereof, alcohol solvents, sulfoxide solvents, or amide solvents can be used. The following describes specific examples of solvents that can be used.

Chlorine solvents such as chloroform, methylene chloride, 1, 2-dichloroethane, 1, 1, 2-trichloroethane, chlorobenzene, and o-dichlorobenzene. Ether solvents such as tetrahydrofuran, dioxane, and anisole. Aromatic hydrocarbon solvents such as toluene, xylene, ethyl benzene, diethyl benzene, trimethyl benzene, n-propyl benzene, isopropyl benzene, n-butyl benzene, isobutyl benzene, s-butyl benzene, epoxy benzene, cyclohexyl benzene, and 1-methylnaphthalene.

Aliphatic hydrocarbon solvents such as cyclohexane, metylcyclohexane, n-pentane, n-hexane, n-heptane, n-octane, n-nonane, n-decane, bicyclohexyl, n-heptyl cyclohexane, n-cyclohexylcyclohexane, and bicyclohexyl. Ketone solvents such as acetone, methl ethyl ketone, cyclohexanone, benzophenone, acetophenone, cyclohexenyl cyclohexanone, 2-propyl cyclohexanone, 2-heptanone, 3-heptanone, 4-heptanone, 2-octanone, 2-nonanone, 2-decanone, and dicyclohexyl ketone bicyclohexyl. Ester solvents such as ethyl acetate, butyl acetate, ethylcellosolve acetate, methyl benzoate, and phenyl acetate.

Polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, and 1,2-hexanediol and derivatives thereof. Alcohol solvents such as methanol, ethanol, propanol, isopropanol, and cyclohexanol. Sulfoxide solvents such as dimethyl sulfoxide. Amide solvents such as N-methyl-2-pyrrolidone, and N,N-dimethylformamide. These organic solvents can be used alone ore a combination of a plurality of these solvents may be used.

From among these solvents, aromatic hydrocarbon solvents, aliphatic hydrocarbon solvents, ester solvents and ketone solvents are preferable from the standpoint of solubility of a polymer compound and the like, uniformity in film formation, viscosity properties, and the like. Toluene, xylene, ethylbenzene, diethylbenzene, trimethylbenzene, n-propylbenzene, i-propylbenzene, n-butylbenzene, isobutylbenzene, s-butylbenzene, anisole, ethoxybenzene, 1-methylnaphthalene, and cyclohexane are more preferable. Other solvents that can be used include cyclohexanone, cyclohexylbenzene, bicyclohexyl, cyclohexenylcyclohexanone, n-heptylcyclohexane, n-hexylcyclohexanone, 2-propylcyclohexanone, 2-heptanone, 3-heptanone, and 4-heptanone. Yet more solvents that can be used include 2-octanone, 2-nonanone, 2-decanone, dicyclohexyl ketone, acetophenone, and benzophenone.

From the standpoint of film formation properties, element properties, and the like, the number of solvents in a solution is preferably two or more, more preferably two or three, yet more preferably two. When two solvents are contained in a solution, one of these solvents may be solid at 25 °C. From the standpoint of film formation properties, it is preferable that one solvent has a boiling point of 180 °C or higher, and a solvent having a boiling point of 200 °C or higher is more preferable. From the standpoint of viscosity, it is preferable that 1 wt% or more of an aromatic polymer at 60 °C is dissolved in two solvents, and it is preferable that one of these solvents has 1 wt% or more of an aromatic polymer at 25 °C dissolved therein.

From the standpoint of viscosity and film formation properties, when two or more solvents are contained in the solution, the amount of the solvent having the highest boiling point is preferably 40 to 90 wt% of the entire solution. An amount of 50 to 90 wt% is more preferable, and an amount of 65 to 85 wt% is even more preferable.

The material for the cathodes 214 is preferably a material that has a low work function for easy electron injection to the light emitting layer, has high electric conductivity, and has a high transmittance of visible light. Suitable metals include alkali metals, alkali earth metals, transitional metals, and III-B metals. Examples of such metals include lithium, sodium, potassium, rubidium, cesium, beryllium, magnesium, calcium, strontium, barium, aluminum, and scandium. Other examples include vanadium, zinc, yttrium, indium, cerium, samarium, europium, terbium, and ytterbium. In addition to any one of these metals, an alloy of two or more of these metals; an alloy including one ore more of these metals and one or more of gold, silver, platinum, copper, manganese, titanium, cobalt, nickel, tungsten, and tin; or graphite or a graphite intercalation compound may be used.

Exemplary alloys include a magnesium-silver alloy, a magnesium-indium alloy, a magnesium-aluminum alloy, an indium-silver alloy, a lithium-aluminum alloy, lithium-magnesium alloy, a lithium-indium alloy, and a calcium-aluminum alloy. Furthermore, a transparent conductive electrode can be used as the cathode, and this electrode may be made of a conductive metal oxide or a conductive organic compound. Specific examples of conductive metal oxides include indium oxide, zinc oxide, tin oxide, and compounds of these oxides, such as indium tin oxide (ITO) and indium zinc oxide (IZO). Examples of conductive organic compounds include polyaniline or a derivative thereof and polythiophene or a derivative thereof. The cathode may include two or more layers. The ion injection layer may sometimes be used as the cathode.

The thickness of the cathode can be selected while considering electrical conduction and endurance, is typically from 10 nm to 10 µm, and is preferably from 20 nm to 1 µm and more preferably from 50 nm to 500 nm. The method for forming the cathode may be vacuum vapor deposition, sputtering, lamination for thermally depositing a metallic thin film, or the like.

In order to protect the elements from the outside so that the organic EL elements can be reliably used for a long time, a protective layer and/or a protective cover may be attached. The protective layer may use a polymer compound, a metal oxide, a metal fluoride, a metal boride, or the like. The protective cover may use a glass board, a plastic board whose surface has been treated to have low water permeability, and the like. The cover is preferably formed by affixing the cover to seal the elements and substrate using a thermal effect resin or a photocurable resin.

If a space is maintained between the cover and the elements using a spacer, the elements can be easily kept from harm. Oxidization of the cathodes can be prevented by sealing a non-volatile gas such as nitrogen or argon in this space. By providing a drying agent such as barium oxide in this space, damage to the elements due to moisture absorbed during the manufacturing process can be prevented. One or more of the protective measures described above may be implemented.

The sealing method may be a widely known method. For example, in a method that involves using a metal substrate or a glass substrate as the sealing substrate, a sealing adhesive agent is applied to the edges of the substrate 202 on which the organic EL elements 201 of the present embodiment are formed, and moisture or oxygen pressure can be expelled therefrom. The substrates are then attached to each other in a vacuum or non-volatile gas atmosphere, and the sealing adhesive agent is then hardened by heating or UV radiation. In order to provide a hygroscopic material inside the sealing substrate, a vacuum workpiece can be used.

As another example of a sealing method, a sealing layer can be formed on the substrate 202 on which the organic EL elements 201 of the present embodiment are formed. An example of this involves forming an organic layer, a multi-layered inorganic film such as SiOx or SiNx, a multi-layered film including organic films and inorganic films, or the like as a gas barrier that blocks moisture or oxygen.

According to the present embodiment, the edge covering layers 212 cover the blue light emitting layer 208, the red light emitting layer 210, and the edges of the edge covering layers 212, thereby decreasing the leak current. Furthermore, the edge covering layers 212 cover the edges of the functional layers, and so peeling at theses edges is prevented. The decrease in the leak current and the prevention of peeling results in the organic EL elements 201 being more reliable and having longer lifetimes.

In addition, the edges of the functional layers can be made non-functional by covering the edges, which have uneven thicknesses, with the edge covering layers 212. Accordingly, variations in the light emission are decreased, thereby improving the uniformity of light emission. Since a coating technique with good mass-production characteristics can be used, the manufacturing cost of the organic EL elements 201 can be decreased. Furthermore, there is no need to adjust complex processing conditions, and so the processing margin is greater and the process can be more easily reproduced.

Fig. 11 is a cross-sectional view of organic EL elements 401, which are examples of other organic EL elements. Fig. 11 shows two organic EL elements 401. Each organic EL element 401 includes a substrate 402, an anode 404, a hole injection layer 406, a blue light emitting layer 408 or a red light emitting layer 410, an edge covering layer 412, and a cathode 414. This difference between this embodiment and the embodiment described above is that, in this case, the banks are not provided. This embodiment can also include many organic EL elements 401 with many colors, in the same manner as the embodiment described above.

The substrate 402 and the anodes 404 may be the same as those of the embodiment described above. However, it should be noted that the substrate 402 does not have the banks. The hole injection layer 406 shown in Fig. 11 is formed over the entire surface of the substrate 402 on which the anodes 404 are formed, but the hole injection layer 406 may instead be formed only on the anodes 404. The hole injection layer 406 is an example of a functional layer.

The blue light emitting layer 408 and the red light emitting layer 410 may be the same as those in the embodiment described above. However, since there are no banks, the element formation regions in the present embodiment are not defined by the banks. In the present embodiment, the blue light emitting layer 408 and the red light emitting layer 410 can be formed by patterning using an etching technique after being formed uniformly as films on the surface of the substrate 402 or by partially coating the substrate 402 with a solution including blue light emitting material and a solution including red light emitting material. This patterning or partial coating defines the element formation regions.

The hole injection layers 406, the blue light emitting layer 408, and the red light emitting layer 410 are examples of functional layers. In the following description, these layers are referred to simply as "functional layers." Furthermore, the hole injection layer 406 and the blue light emitting layer 408 can be referred to collectively as a "functional layer," as can the hole injection layer 406 and the red light emitting layer 410. The hole injection layer 406 is desirably organic. The hole injection layer 406 is an example of an organic carrier injection layer.

The edge covering layers 412 cover the edges of the hole injection layer 406 and the blue light emitting layer 408 and of the hole injection layer 406 and the red light emitting layer 410. The edge covering layers 412 are adhered to the substrate 402 with an adhesive force greater than the adhesive force between the substrate 402 and the functional layers. As a result, the edges of the functional layers are prevented from peeling off.

The edge covering layers 412 may be insulators. Since the functional layers are formed between the substrate 402 and the edge covering layers 412 at the edges thereof, a short circuit between the edges thereof and top electrodes is prevented by forming the edge covering layers 412 as insulators. The edge covering layers 412 may be made of photosensitive resin. If the edge covering layers 412 are a photosensitive resin, regions of the functional layers that are not covered, i.e. functional regions of the functional layers, can be easily formed using photolithography.

The thickness of each edge covering layer 412 is between 10 nm and 10 µm, for example. This thickness is preferably between 100 nm and 5 µm, and more preferably between 1000 nm and 3 µm, for example. The edge covering layers 412 cover the blue light emitting layer 408 and the red light emitting layer 410 from the edge of the element formation region to a location that is between 2 µm and 20 µm, preferably between 5 µm and 15 µm, inward.

The cathodes 414 may be the same as those of the embodiment described above. The blue light emitting layer 408 and the red light emitting layer 410 have their edges covered by the edge covering layers 412, and so the blue light emitting layer 408 and the red light emitting layer 410 each include functional regions that are not covered by the edge covering layers 412. The functional regions are regions that realize the functions of the blue light emitting layer 408 and the red light emitting layer 410, and in this specific case, are light emitting regions. On the other hand, by covering the blue light emitting layer 408 or the red light emitting layer 410 with the edge covering layers 412, non-functional regions can be formed in which the blue light emitting layer 408 and the red light emitting layer 410 are non-functional. As a specific example, regions that do not emit light can be formed.

The blue light emitting layer 408 and the red light emitting layer 410 have a thin film region formed at the edges thereof, and this thin film region has a thickness that is greater than the average thickness of the functional region. The edge covering layers 412 also cover the thin film regions of the functional layers.

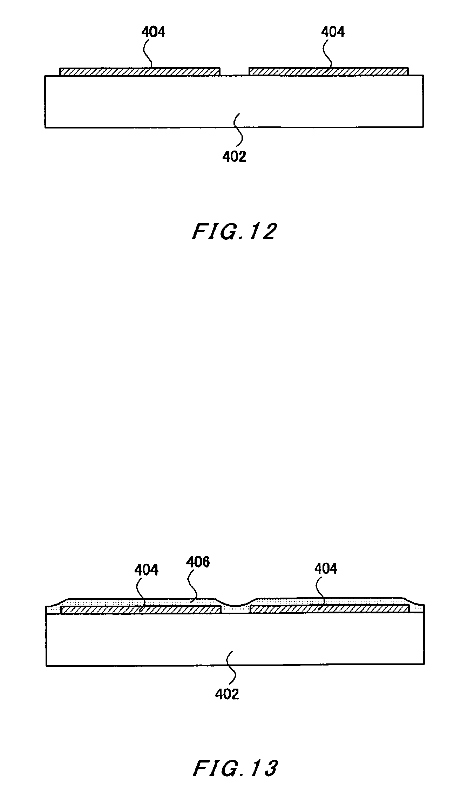

Figs. 12 to 17 are cross-sectional views showing a method for manufacturing organic EL elements 401. As shown in Fig. 12, the substrate 402 is prepared and anodes 404 are formed thereon. The formation of the anodes 404 may be performed in the same way as in the embodiment described above.

As shown in Fig. 13, a coating process or the like may be used to form the hole injection layer 406. After an organic solvent containing a hole injection material is dripped for coating, the hole injection layer 406 can be formed by baking at 400 °C for 30 minutes in a nitrogen atmosphere.

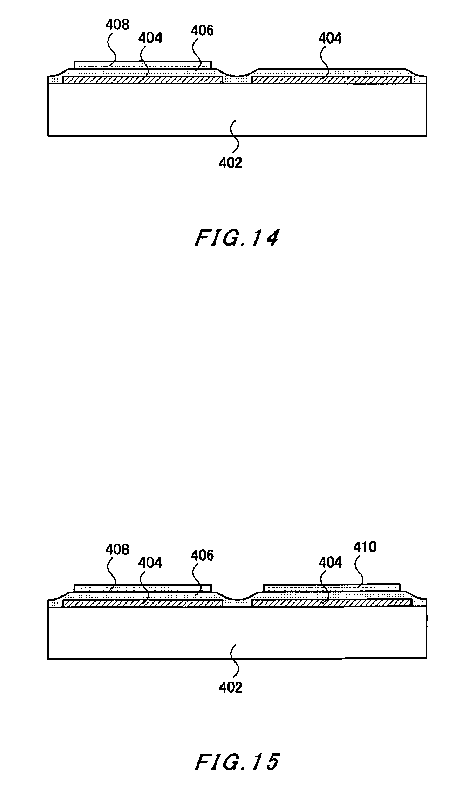

As shown in Fig. 14, the blue light emitting layer 408 is formed on the substrate 402 on which the hole injection layer 406 is formed. The formation of the blue light emitting layer 408 may be performed in the same way as in the embodiment described above. As shown in Fig. 15, the red light emitting layer 410 is formed using the same method as described in Fig. 14. In order to form light emitting layers with several colors, the same process for applying the light emitting layer and patterning should be repeated.

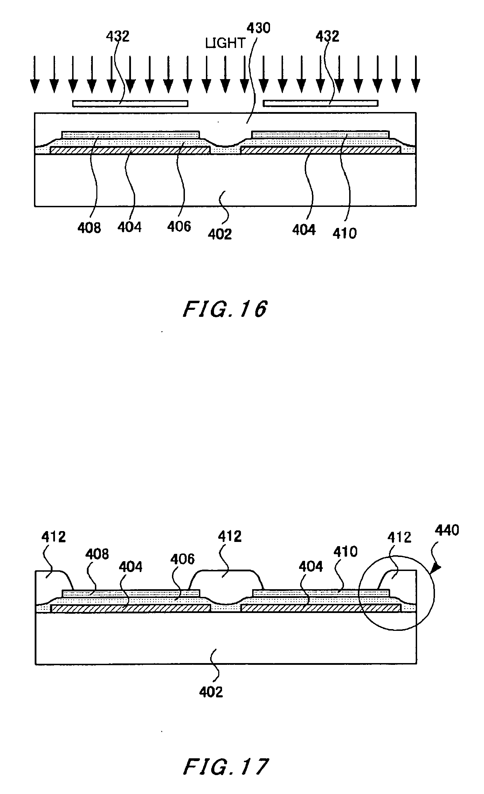

As shown in Fig. 16, a negative resist with an epoxy resin base, for example, is coated on the substrate 402 on which the blue light emitting layer 408 and the red light emitting layer 410 are formed. After the pre-baking, a photomask 432 is disposed and the negative resist 430 is exposed.

As shown in Fig. 17, the edge covering layers 412 are formed by developing the exposed regions of the negative resist 430. After this, if a vapor deposition technique or the like is used to deposit a metal film to form the cathodes 414, the organic EL elements 401 shown in Fig. 11 can be formed.

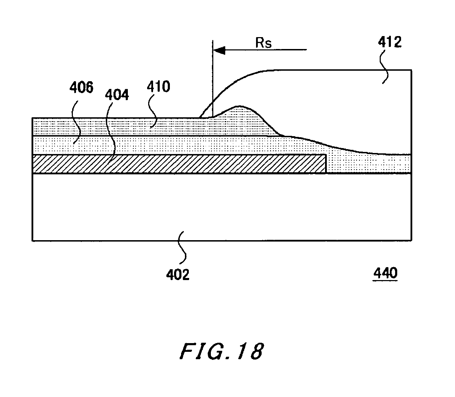

Fig. 18 is a magnified view of the 440 portion of Fig. 17. The set of the hole injection layer 406 and the red light emitting layer 210 has a thin film region Rs formed at the edges thereof, and this thin film region has a thickness that is greater than the average thickness of the functional region. The edge covering layers 412 cover the thin film regions Rs.

According to the present embodiment, the edge covering layers 412 cover the blue light emitting layer 408, the red light emitting layer 410, and the edges of the edge covering layers 412, thereby decreasing the leak current. Furthermore, the edge covering layers 412 cover the edges of the functional layers, and so peeling at theses edges is prevented. The decrease in the leak current and the prevention of peeling results in the organic EL elements 401 being more reliable and having longer lifetimes.

In addition, the edges of the functional layers can be made non-functional by covering the edges, which have uneven thicknesses, with the edge covering layers 412. Accordingly, variations in the light emission are decreased, thereby improving the uniformity of light emission. Since a coating technique with good mass-production characteristics can be used, the manufacturing cost of the organic EL elements 401 can be decreased. Furthermore, there is no need to adjust complex processing conditions, and so the processing margin is greater and the process can be more easily reproduced.

An example of a configuration that can be applied to the organic EL elements 201 or the organic EL elements 401, but was not described in the above embodiments, is now explained. The organic electroluminescent elements are referred to as "organic EL elements" hereinafter.

The organic EL elements of the present embodiment each include an anode, a light emitting layer, and a cathode, and also include another layer between the anode and the light emitting layer and/or between the light emitting layer and the cathode. The layer provided between the cathode and the light emitting layer may be an electron injection layer, an electron transport layer, a hole blocking layer, or the like. If both an electron injection layer and an electron transport layer are provided, the layer closer to the cathode is the electron injection layer and the layer closer to the light emitting layer is the electron transport layer.

The electron injection layer improves the efficiency of electron injection from the cathode. The electron transport layer improves the electron injection from the cathode, the electron injection layer, or an electron transport layer closer to the cathode. If the electron injection layer or the electron transport layer functions to dam transport of holes, these layers may function as the hole blocking layer. The function of damming the transport of holes can be confirmed by a decrease in the electron current value when elements that allow a hole current to flow but do not allow an electron current to flow are created.

The layer provided between the anode and the light emitting layer may be a hole injection layer, a hole transport layer, an electron blocking layer, or the like. If both a hole injection layer and a hole transport layer are provided, the layer closer to the anode is the hole injection layer and the layer closer to the light emitting layer is the hole transport layer.

The hole injection layer improves the efficiency of hole injection from the anode. The hole transport layer improves the hole injection from the anode, the hole injection layer, or a hole transport layer closer to the anode. If the hole injection layer or the hole transport layer functions to dam transport of electrons, these layers may function as the electron blocking layer. The function of damming the transport of the electrons can be confirmed by a decrease in the hole current value when elements that allow an electron current to flow but do not allow a hole current to flow are created.

The organic EL elements of the present embodiment are each provided with one light emitting layer, but may instead be provided with two or more light emitting layers. It should be noted that the electron injection layer and the hole injection layer may be referred to collectively as charge injection layers, and that the electron transport layer and the hole transport layer can be referred to collectively as charge transport layers. As more specific examples, the organic EL elements of the present embodiment may have any of the following layered structures.

a) anode / hole transport layer / light emitting layer / cathode
b) anode / light emitting layer / electron transport layer / cathode
c) anode / hole transport layer / light emitting layer / electron transport layer / cathode
d) anode / charge injection layer / light emitting layer / cathode
e) anode / light emitting layer / charge injection layer / cathode
f) anode / charge injection layer / light emitting layer / charge injection layer / cathode
g) anode / charge injection layer / hole transport layer / light emitting layer / cathode
h) anode / hole transport layer / light emitting layer / charge injection layer / cathode
i) anode / charge injection layer / hole transport layer / light emitting layer / charge injection layer / cathode
j) anode / charge injection layer / light emitting layer / charge transport layer / cathode
k) anode / light emitting layer / electron transport layer / charge injection layer / cathode
l) anode / charge injection layer / light emitting layer / electron transport layer / charge injection layer / cathode
m) anode / charge injection layer / hole transport layer / light emitting layer / charge transport layer / cathode
n) anode / hole transport layer / light emitting layer / electron transport layer / charge injection layer / cathode
o) anode / charge injection layer / hole transport layer / light emitting layer / electron transport layer / charge injection layer / cathode
(Here, and hereinafter, the symbol "/" indicates a border between adjacent layers.)

The organic EL elements of the present embodiment may have more than two light emitting layers. A specific example of an organic EL element with two light emitting layers is shown below.
p) anode / charge injection layer / hole transport layer / light emitting layer / electron transport layer / charge injection layer / electrode / charge injection layer / hole transport layer / light emitting layer / electron transport layer / charge injection layer / cathode

An organic EL element with three or more light emitting layers can be achieved by repeating the combined unit of "electrode / charge injection layer / hole transport layer / light emitting layer / electron transport layer / charge injection layer" two or more times, as shown in the example below.
q) anode / charge injection layer / hole transport layer / light emitting layer / electron transport layer / charge injection layer / combined unit / combined unit... / cathode

In the p and q structures described above, any of the layers except for the anodes, electrodes, cathodes, and light emitting layers may be removed. Here, the electrodes generate holes and electrons by applying an electric field. The electrodes may be vanadium oxide, indium tin oxide, molybdenum oxide, or the like.

The organic EL elements of the present embodiment may also each include a substrate, and each layer may be formed on this substrate. The organic EL elements of the present embodiment may also each include a sealing component that sandwiches the layers with the substrate. An organic EL element having the substrate and layered structure has the substrate on the anode side, but in the present embodiment the substrate may be on either the anode side or the cathode side.

In order to emit light from the light emitting layers, all of the layers in the organic EL elements of the present invention that are on one side of a light emitting layer are formed to be transparent. More specifically, for an organic EL element having a structure of "substrate / anode / charge injection layer / hole transport layer / light emitting layer / electron transport layer / charge injection layer / cathode / sealing component," a so-called bottom-emission type element can be formed by making the substrate, anode, charge injection layer, and hole transport layer all transparent. Instead, a so-called top-emission type element can be formed by making the electron transport layer, charge injection layer, cathode, and sealing component all transparent.

For an organic EL element having a structure of "substrate / cathode / charge injection layer / electron transport layer / light emitting layer / hole transport layer / charge injection layer / anode / sealing component," a so-called bottom-emission type element can be formed by making the substrate, cathode, charge injection layer, and electron transport layer, all transparent. Instead, a so-called top-emission type element can be formed by making the hole transport layer, charge injection layer, anode, and sealing component all transparent. Here, "transparent" means that the visual light transmission rate from the light emitting layer to the layer from which the light is emitted is preferably no less than 40%. If light in the ultraviolet or infrared regions is to be output by the elements, the transmission rates for these regions are preferably no less than 40%.

In order to improve the adhesion to the electrodes or the charge injection from the electrodes, the organic EL elements of the present invention may each be provided with an insulating layer no greater than 2 nm thick or the charge injection layer at a position adjacent to the electrode. In order to improve the interface adhesion or prevent mixing, the organic EL elements of the present invention may each include a thin buffer layer inserted at the interfaces of the light emitting layer or the charge transport layer. The order in which these layers are layered, the number of layers, and the thickness of the layers may be changed as needed according to the desired light emission efficiency or lifetime.

The material for the hole transport layer may be polyvinyl carbazole or a derivative thereof, polysilane or a derivative thereof, a polysiloxane derivative including aromatic amine in a main or side chain, a pyrazoline derivative, an arylamine derivative, a stilbene derivative, or a triphenyldiamine derivative. Other exemplary materials include polyaniline or a derivative thereof, polythiophene or a derivative thereof, polyarylamine or a derivative thereof, polypyrrole or a derivative thereof, poly (p-phenylenevinylene) or a derivative thereof, and poly (2, 5-thienylene vinylene) or a derivative thereof. More specifically, the hole transport materials that can be used are described in Japanese Patent Application Publications No. 63-70257, No. 63-175860, No. 2-135359, No. 2-135361, No. 2-209988, No. 3-37992, and No. 3-152184.

From among these materials, those that are preferable for use in the hole transport layer are polyvinyl carbazole or a derivative thereof, polysilane or a derivative thereof, a polysiloxane derivative including aromatic amine in a main or side chain, polyaniline or a derivative thereof, and polythiophene or a derivative thereof. In addition, preferable polymer hole transport material includes polyarylamine or a derivative thereof, poly (p-phenylenevinylene) or a derivative thereof, and poly (2, 5-thienylene vinylene) or a derivative thereof. Materials that are more preferable include polyvinyl carbazole or a derivative thereof, polysilane or a derivative thereof, and a polysiloxane derivative including aromatic amine in a main or side chain. When a monomer hole transport material is used, this material is preferably dispersed in a polymer binder.

Polyvinyl carbazole or a derivative thereof can be obtained by performing cationic polymerization or radical polymerization on a vinyl monomer, for example. Examples of polysilane or a derivative thereof can be found in Great Britain Patent No. GB2300196 and in "Chemical Review," Vol. 89, page 1359 (1989). The synthesis method used may also be found in these documents, but Kipping's method is particularly suitable. Polysiloxane or a derivative thereof has almost no hole transport properties in a siloxane framework, and so a material having the monomer hole transport material described above in a main or side chain is preferable. In particular, a material having hole transport properties and including aromatic amine in a main or side chain is preferable.

The method for forming the hole transport layer is not particularly limited, but one example is forming the hole transport layer from a mixture of a monomer hole transport material and a polymer binder. Another method is forming the film from a solution with a polymer hole transport material. The solvent used when forming the film from a solution is not particularly limited, as long as the hole transport material can be dissolved in the solvent. Exemplary solvents include chlorine solvents such as chloroform, methylene chloride, and dichloroethane; ether solvents such as tetrahydrofuran; aromatic hydrocarbons such as toluene and xylene; ketone solvents such as acetone and methl ethyl ketone; and ester solvents such as ethyl acetate, butyl acetate, and ethyl cellosolve acetate.

Forming the film from a solution may involve spin coating, casting, microgravure coating, gravure coating, bar coating, roll coating, wire bar coating, and dip coating. Other coating methods that can be used include spray coating, screen printing, flexographic printing, offset printing, and ink jet printing.

The polymer binder in the mixture desirably does not significantly interfere with the charge transport and does not have significant absorption of visible light. Examples of such a polymer binder include polycarbonate, polyacrylate, polymethyl acrylate, polymethyl methacrylate, polystyrene, polyvinyl chloride, and polysiloxane.

The ideal thickness of the hole transport layer changes depending on the material used, and should be selected to achieve the most preferable values for drive voltage and light emission efficiency. The minimum requirement is a thickness large enough to prevent pin holes from occurring. If the layer is too thick, the drive voltage of the element undesirably increases, and this determines the maximum thickness of the layer. Accordingly, the thickness of the hole transport layer is typically from 1 nm to 1 µm, and is preferably 2 nm to 500 nm and more preferably 5 nm to 200 nm.

The electron transport layer may be a widely known electron transport layer, and may be made of an oxadiazole derivative, anthraquinodimethane or a derivative thereof, benzoquinone or a derivative thereof, naphthoquinone or a derivative thereof, anthraquinone or a derivative thereof, tetracyanoanthraquinodimethane or a derivative thereof, or a fluorenone derivative. Other examples include diphenyldicyanoethylene or a derivative thereof, diphenoquinone or a derivative thereof, 8-hydroxyquinoline or a metal complex of a derivative thereof, polyquinoline or a derivative thereof, polyquinoxaline or a derivative thereof, and polyfluorene or a derivative thereof.

From among these materials, an oxadiazole derivative, benzoquinone or a derivative thereof, anthraquinone or a derivative thereof, 8-hydroxyquinoline or a metal complex of a derivative thereof, polyquinoline or a derivative thereof, polyquinoxaline or a derivative thereof, and polyfluorene or a derivative thereof are preferable. Even more preferable are 2-(4-biphenylyl)-5-(4-t-butylphenyl)-1, 3, 4-oxadiazole, benzoquinone, anthraquinone, tris-(8-quinolinol) aluminum, and polyquinoline.

The formation method for the electron transport layer is not particularly limited. The formation method involving a monomer electron transport layer may be vacuum deposition from a powder or formation from a solution or a melt. The formation method involving a polymer electron transport layer may be formation from a solution or a melt. During formation from a solution or a melt, a polymer binder may also be used. The method for forming the electron transport layer from a solution may be the same as the method used for forming the hole transport layer from a solution, as described above.

The ideal thickness of the electron transport layer changes depending on the material used, and should be selected to achieve the most preferable values for drive voltage and light emission efficiency. The minimum requirement is a thickness large enough to prevent pin holes from occurring. If the layer is too thick, the drive voltage of the element undesirably increases, and this determines the maximum thickness of the layer. Accordingly, the thickness of the hole transport layer is typically from 1 nm to 1 µm, and is preferably 2 nm to 500 nm and more preferably 5 nm to 200 nm.

The electron injection layer can be provided between the cathode and the electron transport layer or between the cathode and the light emitting layer. Depending on the type of light emitting layer, the electron injection layer may be made of an alkali metal, an alkali earth metal, an alloy including one or more of these types of metals, a metal oxide containing one of these metals, a halide and a carbonate, or a mixture of the above materials. Examples of alkali metals and oxides, halides, and carbonates thereof include lithium, sodium, potassium, rubidium, cesium, lithium oxide, and lithium fluoride. Other examples include sodium oxide, sodium fluoride, potassium oxide, potassium fluoride, rubidium oxide, rubidium fluoride, cesium oxide, cesium fluoride, and lithium carbonate.

Examples of alkali earth metals and oxides, halides, and carbonates thereof include magnesium, calcium, barium, strontium, magnesium oxide, magnesium fluoride, calcium oxide, and calcium fluoride. Other examples include barium oxide, barium fluoride, strontium oxide, strontium fluoride, and magnesium carbonate.

The electron injection layer may include two or more layers. Examples of this include LiF/Ca or the like. The electron injection layer may be formed using vapor deposition, sputtering, printing, or the like. The thickness of the electron injection layer is desirably from 1 nm to 1 µm.

An insulting layer no greater that 2 nm thick, which can be included in the organic EL element of the present embodiment as desired, facilitates the electron injection. The material for this insulating layer may be a metal nitride, a metal oxide, an organic insulating material, or the like. The organic EL element provided with the insulating layer with a thickness no greater than 2 nm may have this insulating layer provided adjacent to the anode or adjacent to the cathode.

The organic EL element of the present embodiment can be used as a backlight in a flat light source, a segment display apparatus, a dot matrix display apparatus, or a liquid crystal display apparatus. In order to use the organic EL element of the present embodiment in a flat light source, the organic EL element should be arranged such that the flat cathode and anode overlap.

Furthermore, in order to realize a patterned light source, techniques such as placing a mask provided with a pattern window on the surface of the flat light emitting element, forming the organic layers of portions that do not emit light to be thicker to substantially prevent light emission, and forming the electrodes of one or both of the anode and the cathode according to pattern conditions may be used. By forming a pattern using one of these methods and arranging several electrodes to be turned ON or OFF independently, a segment-type display element can be obtained that can display numbers, characters, and simple symbols.

In order to obtain a dot matrix element, the anodes should be formed orthogonal to the cathodes in a striped arrangement. A partial color display or a multi-color display can be achieved by applying a color separation technique to light emitting materials emitting different types of light or by using a fluorescent light filter or color filter. The dot matrix element can perform passive drive, and can perform active drive when combined with a TFT or the like. These display elements may be used as display apparatuses in computers, televisions, cellular terminals, cellular phones, car navigation systems, video camera view finders, or the like.

An image display apparatus having passive matrix drive can be formed by arranging a plurality of the organic electroluminescent elements (organic EL elements) of the present embodiment on a substrate. Furthermore, an image display apparatus having active matrix drive can be formed by using a combination of at least one light emitting element and two transistor elements for each pixel. The light emitting apparatus of the present embodiment can be used in a copy machine, a fax machine, a printer, a scanner, or the like by being combined with an elecrophotographic photosensitive unit. Furthermore, the light emitting apparatus can replace an image with electronic information and store this information by being combined with a CCD or the like.

The organic EL elements of the present embodiment can operate as an image formation apparatus by further providing elements that face a pixel screen and that function by receiving light generated by the pixels. Examples of elements that function by receiving light include electrophotographic photosensitive units, which move charge or lose charge in response to receiving light, CCDs, and the like. For example, the organic EL elements can be used in a copy machine, a fax machine, a printer, a scanner, or the like by being combined with an elecrophotographic photosensitive unit. Furthermore, the organic EL elements can replace an image with electronic information and store this information by being combined with a CCD or the like.

Furthermore, the light emitting unit of the light emitting apparatus of the present embodiment may be made of pixels arranged in one dimension. Instead, the light emitting unit may be made of pixels arranged two-dimensionally in a plane. If a mechanism is included that moves relative to an opposing light receiving unit while maintaining a prescribed gap therebetween, two-dimensional image information can be sequentially rendered.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### [Industrial Applicability]

By covering the edges of the functional layers with the edge covering layers and forming functional regions on portions of the functional layers that are not covered by the edge covering layers, the functional layers can be formed to have highly uniform functional regions.

## Claims

1. An electronic device comprising:
a substrate;
a conductive functional layer formed on the substrate; and
an edge covering layer that covers edges of the functional layer, wherein
the functional layer includes a functional region that is not covered by the edge covering layer.

2. The electronic device according to Claim 1, further comprising a barrier portion that is formed on the substrate, wherein
a functional layer is formed on an element formation region defined by the barrier portion, and the functional layer has a uniform thickness in a central region of the element formation region.

3. The electronic device according to Claim 2, wherein
after applying a solution that includes a photosensitive resin to cover the functional layer, the edge covering layer is formed by removing the photosensitive resin covering the functional region.

4. The electronic device according to Claim 3, wherein
the functional layer includes a lifted region that is formed at the edges of the functional layer by being lifted on a portion of the barrier portion, and
the edge covering layer covers the lifted region of the functional layer.

5. The electronic device according to Claim 4, wherein
the functional layer includes a thin film region whose thickness is less than an average thickness of the functional region, the thin film region being formed at the edges of the functional layer, and
the edge covering layer covers the thin film region of the functional layer.

6. The electronic device according to Claim 1, further comprising a barrier portion formed on the substrate, wherein
the functional layer is formed on an element formation region defined by the barrier portion, and
after applying a solution that includes a photosensitive resin to cover the functional layer, the edge covering layer is formed by removing the photosensitive resin covering the functional region.

7. The electronic device according to Claim 6, wherein
the functional layer includes a lifted region that is formed at the edges of the functional layer by being lifted on a portion of the barrier portion, and
the edge covering layer covers the lifted region of the functional layer.

8. The electronic device according to Claim 7, wherein
the functional layer includes a thin film region whose thickness is less than an average thickness of the functional region, the thin film region being formed at the edges of the functional layer, and
the edge covering layer covers the thin film region of the functional layer.

9. The electronic device according to Claim 1, wherein
the functional layer is formed by patterning a uniformly formed film on the substrate without forming a barrier portion on the substrate, or by forming a film in a region that is part of the substrate without forming the barrier portion on the substrate.

10. The electronic device according to Claim 9, wherein
after applying a solution that includes a photosensitive resin covering the functional layer, the edge covering layer is formed by removing the photosensitive resin covering the functional region.

11. The electronic device according to Claim 9, wherein
the functional layer includes a thin film region whose thickness is greater than an average thickness of the functional region, the thin film region being formed at the edges of the functional layer, and
the edge covering layer covers the thin film region of the functional layer.

12. The electronic device according to Claim 1, wherein
the functional layer further includes a non-functional region that is made non-functional by covering the functional layer with the edge covering layer.

13. The electronic device according to Claim 1, wherein
the edge covering layer is adhered to the substrate by an adhesion force that is greater than an adhesion force between the substrate and the functional layer.

14. The electronic device according to Claim 1, wherein
the functional layer is a light emitting layer.

15. The electronic device according to Claim 14, wherein
the light emitting layer is an organic light emitting layer, and
the functional layer further includes an organic carrier injection layer between the light emitting layer and the substrate.

16. The electronic device according to Claim 1, wherein
the functional layer is formed by a coating technique.

17. The electronic device according to Claim 1, wherein
the edge covering layer includes a photosensitive resin.

18. The electronic device according to Claim 1, further comprising a pair of opposing electrodes that sandwich the functional layer and supply current to the functional layer, wherein
the edge covering layer isolates a leak current between the pair of electrodes at the edges of the functional layer.

19. A display apparatus comprising:
a substrate; and
display elements arranged in a matrix on the substrate, wherein
the display elements include a conductive functional layer formed on the substrate and an edge covering layer that covers edges of the functional layer, and
the functional layer includes a functional region that is not covered by the edge covering layer.

20. The display apparatus according to Claim 19, wherein
the functional layer is formed by patterning a uniformly formed film on the substrate without forming a barrier portion on the substrate, or by forming a film in a region that is part of the substrate without forming the barrier portion on the substrate.

21. The display apparatus according to Claim 19, wherein
element formation regions of the display elements are arranged in a matrix by arranging a barrier portion on the substrate in a row direction and a column direction, and
the functional layer has a uniform thickness in a central region of the element formation region.

22. The display apparatus according to Claim 19, wherein
element formation regions of the display elements are formed in a matrix by arranging the barrier portion on the substrate in a row direction and a column direction, and
after applying a solution that includes a photosensitive resin covering the functional layer, the edge covering layer is formed by removing the photosensitive resin covering the functional region.

23. An electronic device manufacturing method comprising:
forming a functional layer by patterning a uniformly formed film on a substrate or by forming a film in a region that is part of the substrate;
forming a covering layer that covers the functional layer; and
forming an edge covering layer that covers edges of the functional layer by removing the covering layer from a central region of the functional layer.

24. The electronic device manufacturing method according to Claim 23,
wherein
forming the covering layer includes coating with a photosensitive covering layer, and
forming the edge covering layer includes using a photolithography technique on the photosensitive covering layer and removing the photosensitive covering layer from a central region of the functional layer.

25. An electronic device manufacturing method comprising:
forming a barrier portion on a surface of a substrate;
forming a functional layer that is separated by the barrier portion on the substrate on which the barrier portion is formed;
forming a covering layer that covers the barrier portion and the functional layer; and
forming an edge covering layer that covers edges of the functional layer by removing the covering layer from a central region of the functional layer.

26. The electronic device manufacturing method according to Claim 25,
wherein
forming the covering layer includes coating with a photosensitive covering layer, and
forming the edge covering layer includes using a photolithography technique on the photosensitive covering layer and removing the photosensitive covering layer from a central region of the functional layer.
